Europäisches Patentamt

European Patent Office

Office européen des brevets

(19)

(11) Numéro de publication : **0 379 454 B1**

(12)
# FASCICULE DE BREVET EUROPEEN

(45) Date de publication du fascicule du brevet :
23.03.94 Bulletin 94/12

(51) Int. Cl.$^5$ : **H03K 17/06, G05F 1/575**

(21) Numéro de dépôt : **90420029.2**

(22) Date de dépôt : **19.01.90**

(54) **Circuit à transistor MOS de puissance commandé par un dispositif à deux pompes de charge symétriques.**

(30) Priorité : **23.01.89 FR 8901231**

(43) Date de publication de la demande :
**25.07.90 Bulletin 90/30**

(45) Mention de la délivrance du brevet :
**23.03.94 Bulletin 94/12**

(84) Etats contractants désignés :
**DE FR GB IT NL**

(56) Documents cités :
**US-A- 4 560 918**
**US-A- 4 803 612**

(56) Documents cités :
**IBM TECHNICAL DISCLOSURE BULLETIN,
vol. 14, no. 12, mai 1972, page 3756, New York,
US; J.G. BARCOMB: "Opposite polarity voltage generator"
FUNKSCHAU, vol. 4B, no. 6, mars 1976, pages
215-216, Munich, DE; K.P. EFFENBERGER:
Mehrkanalige Tonaufzeichnung mit Hilfe digital angesteuerter schneller Analog-Schalter"**

(73) Titulaire : **SGS-THOMSON
MICROELECTRONICS S.A.
7, Avenue Galliéni
F-94250 Gentilly (FR)**

(72) Inventeur : **Barou, Michel
2, Résidence Bouvardière
F-38340 Voreppe (FR)**

(74) Mandataire : **de Beaumont, Michel
1bis, rue Champollion
F-38000 Grenoble (FR)**

## Description

La présente invention concerne le domaine des transistors MOS de puissance, et plus particulièrement les transistors MOS de puissance réalisés selon la technologie dite DMOS (MOS diffusé) à canal N qui nécessitent, quand leur drain est relié à une source d'alimentation et leur source à une charge, une tension de grille supérieure à la tension d'alimentation.

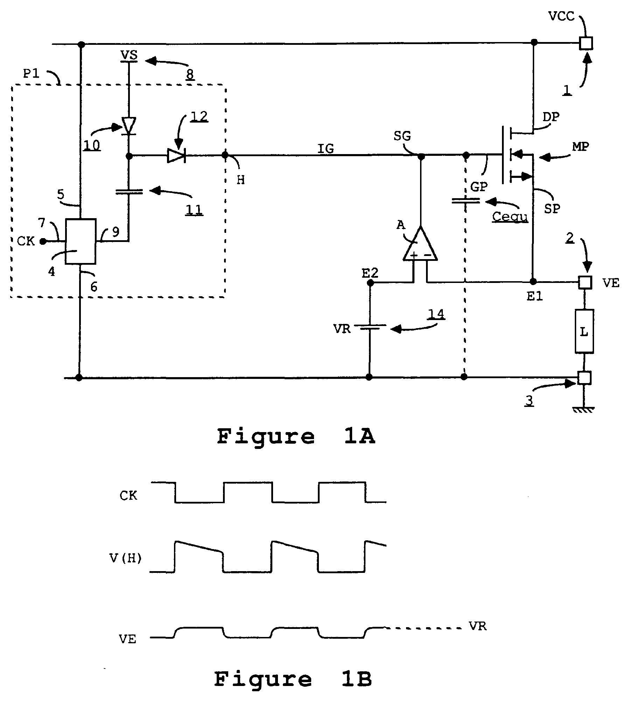

La figure 1A représente un circuit comprenant un transistor MOS de puissance MP à canal N dont le drain DP est relié à une première borne 1 d'une source d'alimentation qui délivre une tension VCC positive et dont la source SP est reliée à une borne de sortie 2 du circuit. Une charge L est connectée entre cette borne de sortie 2 et la deuxième borne 3 de la source d'alimentation. Habituellement, la borne 3 est connectée à la masse.

De façon classique, la tension de grille supérieure à la tension d'alimentation est fournie par un circuit dit "pompe de charge" dont un exemple est représenté dans le block P1. Un commutateur 4 est connecté par des bornes 5 et 6 aux bornes 1 et 3 de la source d'alimentation, respectivement. Il est relié à une horloge CK par une borne 7. Une source de tension auxiliaire 8, qui est interne au circuit et qui délivre une tension auxiliaire positive VS inférieure ou égale à VCC, est reliée à la borne de sortie 9 du commutateur par l'intermédiaire d'une diode 10 polarisée en direct et d'une capacité 11. Celle des bornes de la capacité qui n'est pas connectée au commutateur est reliée à l'anode d'une diode 12 dont la cathode constitue la borne de sortie H de la pompe de charge.

Le signal d'horloge (courbe CK de la figure 1B) est formé d'une suite alternée régulière de niveaux hauts et de niveaux bas. Quand ce signal d'horloge est à son niveau haut, la sortie 9 du commutateur est reliée à la borne 3 de la source d'alimentation. Quand le signal d'horloge est à son niveau bas, la sortie 9 est reliée à la borne 1 de la source d'alimentation.

La sortie H de la pompe de charge est appliquée à la grille GP du transistor MOS MP à laquelle elle fournit des impulsions de courant IG.

Le fonctionnement de ce circuit va être expliqué en relation avec la figure 1B qui représente le signal d'horloge CK, la tension V(H) au point H et la tension VE sur la borne de sortie 2 du circuit.

Quand le signal d'horloge CK est à son niveau haut, reliant ainsi la sortie 9 du commutateur à la masse, la capacité 11 se charge à une tension VS-Vd (Vd étant la chute de tension en direct d'une diode). La tension V(H) au point H est égale à VS-2Vd. Quand le signal d'horloge passe au niveau bas, la borne 9 étant alors reliée à la borne 1 sur laquelle est appliquée la tension VCC, la tension V(H) devient égale à VCC+VS-2Vd. La tension VCC+VS-2Vd est appliquée sur la capacité équivalente Cequ présente entre la grille du transistor MOS MP et la masse, la capacité Cequ stockant cette tension pendent les passages de l'horloge à niveau haut et se rechargeant lors de chaque passage de l'horloge à niveau bas.

Ainsi, la pompe de charge P1 permet de générer, de manière impulsionnelle, une tension V(H) supérieure à la tension de la source d'alimentation VCC sans avoir recours à une source d'alimentation externe au circuit.

Le montage à pompe de charge à fonctionnement par impulsions donne des résultats satisfaisants pour l'alimentation de la grille d'un transistor MOS tel que décrit ci-dessus. Toutefois, des problèmes se posent quand on veut associer au circuit de commande des fonctions particulières, par exemple une régulation de la tension de sortie.

Dans la figure 1A, une telle régulation est assurée par un amplificateur opérationnel A muni d'une première entrée E1 connectée à la borne de sortie 2 et d'une deuxième entrée E2 reliée à la borne 3 de la source d'alimentation par l'intermédiaire d'une source de tension de référence 14 de valeur VR. La sortie SG de l'amplificateur opérationnel A est connectée à la grille GP du transistor MOS de puissance MP. L'amplificateur opérationnel ajuste la tension de grille du transistor MP pour maintenir la tension de sortie VE sur la borne de sortie 2 du circuit à la tension de référence VR.

Cependant, lors de la régulation, il se pose, avec le circuit de la figure 1A, le problème de la génération d'un bruit parasite qui pertube le signal de sortie et empêche l'utilisation de ce circuit lorsqu'une grande stabilité du signal est requise.

Ce bruit provient de l'association de l'amplificateur opérationnel à une pompe de charge fournissant un courant IG de façon impulsionnelle. Pour en déterminer la cause précise et essayer d'y remédier, il est nécessaire d'examiner en détail la structure de l'amplificateur opérationnel.

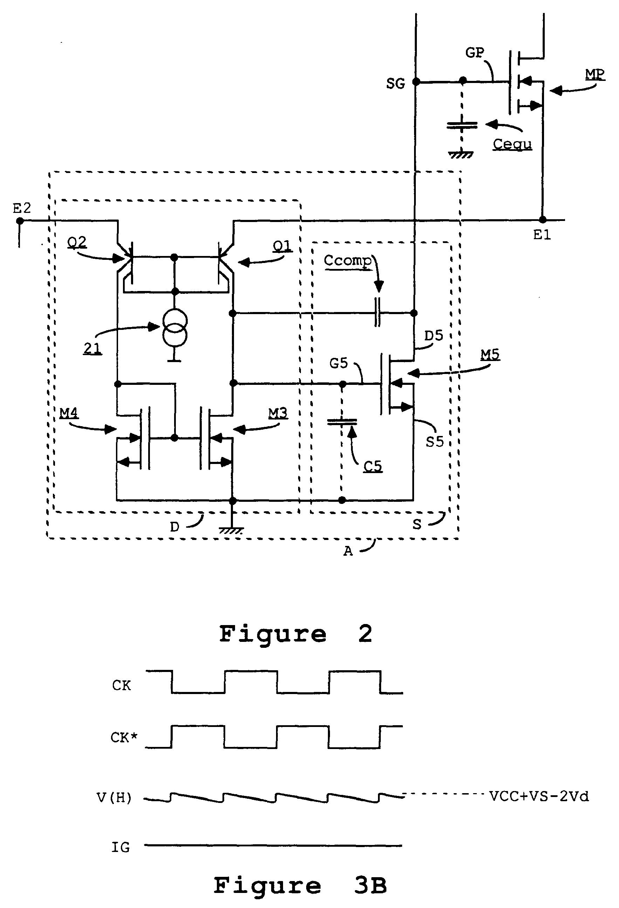

La figure 2 représente un mode de réalisation de l'amplificateur opérationnel A de la figure 1A. Cet amplificateur opérationnel comprend un étage différentiel D et un étage de sortie S. L'étage différentiel D comprend de façon classique une paire de transistors bipolaires Q1, Q2 reliés de la façon représentée à des transistors MOS de charge M3 et M4, respectivement, du type transistor MOS logique, et à une source de courant 21.

L'étage de sortie S comprend un transistor MOS logique M5 dont le drain D5 constitue la sortie SG de l'amplificateur opérationnel A et une capacité de compensation Ccomp destinée à assurer la stabilité de l'asservissement.

Pendant les périodes actives de la pompe de charge, le transistor M5 est passant et sa capacité grille-source C5 se charge. Pendant les périodes inactives, le transistor M5 se bloque. Cependant, la capacité C5 ne se décharge pas instantanément et la tension encore présente sur sa grille G5 maintient le transistor M5 passant pendant un petit laps de temps avant cette mise à l'état bloqué. Il en résulte une diminution de la charge de la capacité Cequ et un abaissement de la tension de grille du transistor MOS de puissance MP. La tension VE sur la borne de sortie 2 diminue. Quand le courant IG est à nouveau généré, la capacité Cequ est rechargée, la tension de grille du transistor MP augmente, la tension VE remonte à la valeur VR et l'amplificateur opérationnel redevient en mode d'asservissement. C'est ainsi la présence de la capacité grille-source C5 du transistor M5 qui est à l'origine du bruit. Sur la figure 1B, le niveau de la tension de référence VR est indiqué en pointillés en face de la courbe VE.

Pour essayer de résoudre le problème susmentionné du bruit, des efforts ont été concentrés dans l'art antérieur sur l'amplificateur opérationnel.

Une première manière de diminuer le bruit consisterait notamment à réduire les dimensions du transistor M5 pour en diminuer la capacité grille-source.

Cependant, pour assurer la stabilité de l'asservissement dans un circuit du type représenté, le critère de stabilité suivant doit être respecté :

$$gml/Ccomp < gm5/Cequ \quad \text{(relation 1)}$$

gml étant la pente de l'amplificateur différentiel et gm5 la pente du transistor MOS M5, il n'est pas possible de diminuer de façon importante les dimensions de ce transistor et donc la valeur de la capacité C5 si l'on veut que la relation 1 reste vraie.

Une deuxième manière de diminuer le bruit consisterait à supprimer la cause qui en a été indiquée précédemment, à savoir la capacité C5. Pour cela, il conviendrait d'utiliser au lieu d'un transistor MOS un transistor bipolaire.

Toutefois, cette solution serait incompatible avec les technologies actuellement utilisées pour réaliser simultanément des transistors MOS de puissance (tel que le transistor MP), des transistors MOS logiques (tels que les transistors M3 et M4), et des transistors bipolaires (tels que les transistors Q1 et Q2). En effet, dans ces technologies, un transistor bipolaire présente une diode dont l'anode est constituée par le substrat et la cathode par le collecteur. Si le substrat venait à être coupé de la masse, un signal perturbateur parviendrait à la grille du transistor MOS de puissance MP par l'intermédiaire de cette diode.

C'est ce qui fait que l'on est inévitablement amené à utiliser un transistor MOS M5 de type logique pour l'étage de sortie comme cela a été indiqué précédemment.

La présente invention propose une nouvelle solution au problème posé.

Selon l'invention, plutôt que d'essayer de perfectionner l'amplificateur d'asservissement, on propose de supprimer le fonctionnement impulsionnel de la pompe de charge.

Plus précisément, la présente invention prévoit de combiner à la pompe de charge décrite précédemment une deuxième pompe de charge fonctionnant en alternance avec la première.

En outre, étant donné qu'une pompe de charge, ou une paire de pompes de charge fournit un courant en impulsions, la présente invention prévoit de lisser le courant de grille au moyen d'un circuit à miroir de courant.

Ces objets, caractéristiques et avantages ainsi que d'autres de la présente invention seront exposés plus en détail dans la description suivante d'un mode de réalisation particulier faite en relation avec les figures jointes parmi lesquelles :

les figures 1A et 1B, déjà décrites, représentent d'une part un circuit selon l'art antérieur (figure 1A) et d'autre part un ensemble de courbes correspondant à l'évolution dans le temps de signaux de tension par rapport à un signal d'horloge (figure 1B) ;

la figure 2 représente une vue détaillée de la structure d'un amplificateur opérationnel du circuit de la figure 1A selon l'art antérieur ; et

les figures 3A et 3B représentent d'une part un circuit selon la présente invention (figure 3A) et d'autre part un ensemble de courbes correspondant à l'évolution dans le temps de signaux de tension et de courant par rapport à des signaux d'horloge (figure 3B).

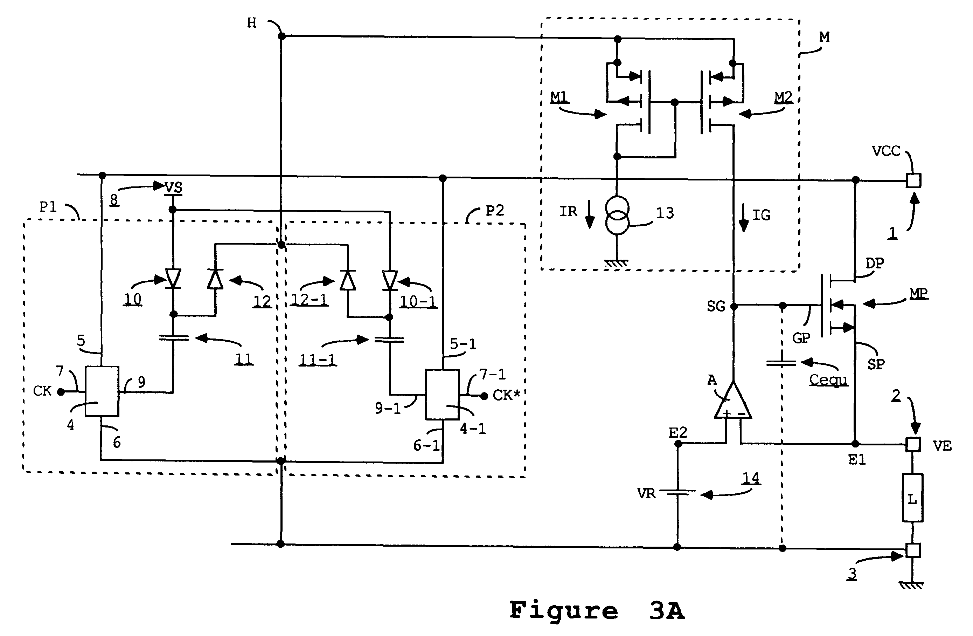

La figure 3A représente un circuit selon la présente inention. On retrouve, comme sur la figure 1A, le transistor MOS de puissance MP, la charge L, la boucle d'asservissement comprenant l'amplificateur opérationnel A, et la pompe de charge P1.

Par rapport au circuit de la figure 1A, il a été rajouté une deuxième pompe de charge P2 symétrique de la première pompe de charge P1 et un miroir de courant M.

La deuxième pompe de charge comprend un commutateur 4-1 ayant une borne 5-1 et une borne 6-1 connectées aux bornes 1 et 3 de la source d'alimentation, respectivement. Ce commutateur comprend également une borne 7-1 recevant des signaux d'horloge inversés CK∗ et une sortie 9-1 reliée à la source de tension auxiliaire 8 par l'intermédiaire d'une diode 10-1, polarisée en direct, et d'une capacité 11-1 située entre la diode 10-1 et le commutateur 4-1. Celle des bornes de la capacité 11-1 qui n'est pas connectée au commutateur 4-1 est reliée à l'anode d'une diode 12-1 dont la cathode est reliée à la borne de sortie H de la pompe de charge P1, cette cathode constituant la sortie de la pompe de charge P2.

Le miroir de courant M comprend par exemple deux transistors MOS à canal P M1 et M2 dont les grilles et les sources sont interconnectées l'une à l'autre. Le drain D1 du transistor M1 est relié à sa grille et à une source de courant 13 imposant le passage d'un courant IR dans ce transistor et d'un courant proportionnel IG dans le transistor M2. Le drain D2 est relié à la grille GP du transistor MOS de puissance MP. Les sources S1 et S2 sont reliées à la borne H.

Les pompes de charge P1 et P2 fonctionnant en alternance l'une avec l'autre, la tension V(H) est maintenue, sans discontinuité, à un niveau proche de VCC+VS-2Vd. Cette tension reste donc supérieure ou égale à la tension de la grille GP et un courant IG circule en permanence. Grâce au circuit à miroir de courant, le courant IG est constant et non pas impulsionnel comme cela résulterait, en son absence, des phases de charge et de décharge brutale des condensateurs 11 et 11-1. Il en résulte que le problème de la charge et de la décharge de la capacité grille-source du transistor de l'étage de sortie de l'amplificateur ne se pose plus.

Le fonctionnement du circuit est illustré par les courbes de la figure 3B qui représentent le signal d'horloge CK, le signal d'horloge inversé CK*, la tension V(H) au point H et le courant IG qui traverse le transistor M2.

En plus de la suppression du bruit, l'utilisation du procédé selon l'invention permet de choisir librement les dimensions du transistor M5 puisque la valeur de sa capacité grille-source peut être augmentée sans inconvénient. En particulier, on pourra augmenter de façon notable ses dimensions pour améliorer la stabilité de l'asservissement.

## Revendications

1. Circuit comprenant un transistor MOS de puissance (MP) du type nécessitant pour sa mise en conduction une tension de grille supérieure à la tension d'alimentation (VCC) quand son drain (DP) est relié à la source d'alimentation et sa source (SP) à une charge (L), et comprenant pour réguler sa tension de sortie une boucle d'asservissement (A, 14) agissant sur la grille du transistor MOS dont la tension de mise en conduction est fournie par un circuit élévateur formé d'un premier circuit du type à diode-capacité dit première pompe de charge (P1), ce circuit étant réalisé dans une technologie susceptible d'incorporer dans une même puce de circuit intégré des transistors MOS de puissance, des transistors MOS logiques et des transistors bipolaires, caractérisé en ce que le circuit élévateur comprend un deuxième circuit du type à diode-capacité dit deuxième pompe de charge (P2) fonctionnant en alternance avec le premier et en ce que la première branche (M2) d'un miroir de courant (M), dont la deuxième branche (M1) est reliée à une source de courant prédéterminé (13), est intercalée entre le circuit élévateur et la grille (GP) du transistor MOS de puissance (MP).

2. Circuit selon la revendication 1, caractérisé en ce que chaque pompe de charge (P1, P2) comprend :
- un commutateur (4, 4-1) fournissant un signal en créneaux, et
- un montage en série d'une capacité (11, 11-1) et d'une première diode (10, 10-1), ce montage étant connecté entre une source de tension auxiliaire (8) et la sortie (9, 9-1) du commutateur, de sorte que la capacité se charge quand la sortie du commutateur est à bas niveau, une deuxième diode (12, 12-1) étant connectée entre le point de connexion de la capacité et de la première diode et une borne d'utilisation (H) ;

et en ce que les commutateurs des deux pompes de charge fonctionnent en opposition de phase.

3. Circuit selon la revendication 1, caractérisé en ce que la boucle d'asservissement est composée d'un amplificateur opérationnel (A) et d'une source de tension de référence (14), l'amplificateur opérationnel comprenant une première entrée (E1) connectée à la source (SP) du transistor MOS de puissance (MP), une deuxième entrée (E2) reliée à la source de tension de référence et une sortie (SG) reliée à la grille (GP) du transistor MOS.

## Patentansprüche

1. Schaltkreis mit einem MOS-Leistungstransistor (MP), der zum Erreichen eines leitenden Zustandes eine Gatespannung benötigt, die höher ist als die Versorgungsspannung (VCC), wenn sein Drain (DP) mit der Versorgungsquelle verbunden ist und sein Source (SP) mit einer Last (L) verbunden ist, und mit einer Regelschleife (A, 14) zum Regeln seiner Ausgangsspannung, die auf das Gate des MOS-Transistors einwirkt, wobei die Spannung, die diesen in den leitenden Zustand bringt, von einer Verstärkerschaltung geliefert wird, die aus einer ersten Dioden-Kondensator-Schaltung gebildet ist, die als erste Ladepumpe (P1) bezeichnet ist, wobei die Schaltung in einer Technologie ausgeführt ist, die in ein- und demselben integrierten Schaltkreischip MOS-Leistungstransistoren, logische MOS-Transistoren und bipolare Transistoren unterbringen kann, dadurch gekennzeichnet, daß die Verstärkerschaltung eine zweite Dioden-Kondensator-Schaltung aufweist, die als zweite Ladepumpe (P2) bezeichnet ist, welche abwechselnd mit der ersten Ladepumpe arbeitet, und daß der erste Zweig (M2) einer Stromspiegelschaltung (M), deren zweiter Zweig (M1) mit einer vorgegebenen Stromquelle (13) verbunden ist, zwischen der Verstärkerschaltung und dem Gate (GP) des MOS-Leistungstransistors (MP) eingeschaltet ist.

2. Schaltkreis nach Anspruch 1, dadurch gekennzeichnet, daß jede Ladepumpe (P1, P2) folgende Merkmale aufweist:
   - einen Schalter (4, 4-1), der ein Rechtecksignal liefert, und
   - eine Reihenschaltung aus einem Kondensator (11, 11-1) und einer ersten Diode (10, 10-1), wobei die Schaltung zwischen einer Hilfsspannungsquelle (8) und dem Ausgang (9, 9-1) des Schalters angeschlossen ist, so daß sich der Kondensator auflädt, wenn der Schalter auf einen niedrigen Pegel gelegt ist, wobei eine zweite Diode (12, 12-1) zwischen dem Verbindungspunkt des Kondensators und der ersten Diode und einem Ausgangsanschluß (H) angeschlossen ist,
   und daß die Schalter der beiden Ladepumpen gegenphasig arbeiten.

3. Schaltkreis nach Anspruch 1, dadurch gekennzeichnet, daß die Regelschleife aus einem Operationsverstärker (A) und einer Bezugsspannungsquelle (14) besteht, wobei der Operationsverstärker (A) einen ersten Eingang (E1) aufweist, der mit der Source (SP) des MOS-Leistungstransistors (MP) verbunden ist, einen zweiten Eingang (E2) aufweist, der mit der Bezugsspannungsquelle verbunden ist, und einen Ausgang (SG) aufweist, der mit dem Gate (GP) des MOS-Transistors verbunden ist.

**Claims**

1. A circuit comprising a power MOS transistor (MP) requiring for being set in a conductive state a gate voltage higher than the supply voltage (VCC) when its drain (DP) is connected to the supply source and its source (SP) is connected to a load (L), and comprising for regulating its output voltage a control loop (A, 14) acting on the gate of the MOS transistor, the conductive voltage of which is supplied by a booster circuit formed by a first circuit of the diode-capacitor type, called first charge pump (P1), said circuit being realized according to a technology liable to incorporate, in a same integrated circuit chip, power MOS transistors, logic MOS transistors and bipolar transistors, characterized in that the booster circuit comprises a second diode-capacitor type circuit, called second charge pump (P2), alternatively operating with the first one and in that the first leg (M2) of a current mirror (M), the second leg (M1) of which is connected to a predetermined current source (13), is placed between the booster circuit and the gate (GP) of a power MOS transistor (MP).

2. A circuit according to claim 1, characterized in that each charge pump (M1, M2) comprises:
   - a switch (4, 4-1) supplying a square wave signal, and
   - a series circuit comprising a capacitor (11, 11-1) and a first diode (10, 10-1), said circuit being connected between an auxiliary voltage source (8) and the output (9, 9-1) of the switch, so that, the capacitor is charged when the switch output is at low level, a second diode (12, 12-1) being connected between the connection point of the capacitor and said first diode and an output terminal (H);
   and in that the switches of the two charge pumps operate in phase opposition.

3. A circuit according to claim 1, characterized in that the control loop is comprised of an operational amplifier (A) and a reference voltage source (14), the operational amplifier comprising a first input (E1) connected to the source (SP) of the power MOS transistor (MP), a second input (E2) connected to the source of the reference voltage and an output (SG) connected to the gate (GP) of the MOS transistor.

## Figure 1A

## Figure 1B

## Figure 2

## Figure 3B

Figure 3A